# EUROPEAN PATENT SPECIFICATION

(11) **EP 1 803 164 B1**
(45) Date of publication and mention of the grant of the patent: **14.12.2011**
(21) Application number: 05793565.2
(22) Date of filing: 11.10.2005
(51) Int. Cl.: H01L 33/00

(54) **LUMINESCENT LIGHT SOURCE, METHOD FOR MANUFACTURING THE SAME, AND LIGHT-EMITTING APPARATUS**
LUMINESZENTE LICHTQUELLE, VERFAHREN ZU IHRER HERSTELLUNG UND LICHT EMITTIERENDE VORRICHTUNG
SOURCE DE LUMIERE LUMINESCENTE, PROCEDE DE FABRICATION DE LADITE SOURCE ET APPAREIL LUMINESCENT

(30) Priority: 13.10.2004 JP 2004299312
(43) Date of publication of application: 04.07.2007
(73) Proprietor: Panasonic Corporation, Kadoma-shi Osaka 571-8501 (JP)
(72) Inventor: TANIMOTO, Noriyasu, Chuo-ku Osaka-shi Osaka 540-6319 (JP); YANO, Tadashi, Chuo-ku Osaka-shi Osaka 540-6319 (JP); TAKAHASHI, Kiyoshi, Chuo-ku Osaka-shi Osaka 540-6319 (JP); SHIMIZU, Masanori, Chuo-ku Osaka-shi Osaka 540-6319 (JP); OGATA, Toshifumi, Chuo-ku Osaka-shi Osaka 540-6319 (JP)
(74) Representative: Tomlinson, Kerry John
(86) International application number: PCT/JP2005/018996
(87) International publication number: WO 2006/041178

(56) References cited:
- EP-A- 1 367 655
- US-A1- 2002 070 449
- US-A1- 2003 102 481

## Description

### Technical Field

The present invention relates to a luminescent light source using a light-emitting element, specifically, a light-emitting diode bare chip, a method for manufacturing the same, and a light-emitting apparatus using the luminescent light source.

### Background Art

In recent years, a luminescent light source using a light-emitting diode bare chip (hereinafter, referred to as a LED bare chip) has been attracting attention as a next-generation illumination light source. The reason behind this is that a luminescent light source using a LED bare chip has longer life and uses no Hg so as to be environmentally friendly compared with conventional incandescent lamps and fluorescent lamps. Another reason is that a LED bare chip itself is small and thus allows a luminescent light source to be reduced in size and weight.

Examples of a luminescent light source using a LED bare chip include a luminescent light source that includes a LED bare chip, a substrate connected to the LED bare chip, and a phosphor layer that contains a phosphor and covers the LED bare chip. Particular attention has been given to, among luminescent light sources of such a type, a luminescent light source that produces white output light by using a LED bare chip emitting blue light and a phosphor that is contained in a phosphor layer and emits yellow light.

Meanwhile, an electrical connection between a LED bare chip and a substrate is established by, for example, a method in which the LED bare chip bonded to the substrate via a non-conductive paste is connected to the substrate using a plurality of gold wires, a method in which the LED bare chip bonded to the substrate via a conductive paste or Au-Sn eutectic bonding is connected to the substrate using a gold wire, or a flip-chip connection method in which the LED bare chip is connected to the substrate via a bump. When the above-described luminescent light source using a LED bare chip is used as an illumination light source, the flip-chip connection method using no wire is more suitable since in the methods of establishing an electrical connection using a wire, it is likely that the shadow of the wire is projected on a surface to be irradiated.

In the flip-chip connection method, generally, a LED bare chip is connected electrically to a conductor pattern on a substrate via a bump formed of gold or solder. In this case, the bump is formed directly on the LED bare chip or the conductor pattern formed on the substrate. Further, there also is a method in which after a LED bare chip is connected to a substrate, an underfill further is filled into a gap between the LED bare chip and the substrate (see, for example, JP 2003-101075 A). An underfill generally is a liquid material formed of, for example, a resin such as an epoxy resin or the like. Through the use of this, the bonding between a LED bare chip and a substrate can be reinforced. Further, through the use of an underfill further containing an inorganic filler, stress exerted on a bump can be reduced, and thus, for example, a phenomenon can be prevented in which a LED bare chip is peeled off from a wring pattern on a substrate due to heat applied in a later process and in actual use.

However, an underfill may run up to a side face of a LED bare chip or spread to an area other than an area between the LED bare chip and a substrate. Such a case causes a phosphor layer to have an unstable shape, that is, the phosphor layer covering the LED bare chip to have a non-uniform thickness, leading to uneven chromaticity of output light, which is problematic.

Moreover, in the case where an underfill and a phosphor layer are formed of different materials from each other, particularly, when the phosphor layer contains a silicone resin having less adhesiveness, peeling is likely to occur at an interface between the underfill and the phosphor layer, which also is problematic.

Furthermore, in order to form a phosphor layer three-dimensionally so as to cover a LED bare chip and maintain the shape of the phosphor layer, a material constituting the phosphor layer should have a high viscosity. Because of this, without the use of an underfill, in a conventional method, a material constituting a phosphor layer hardly flows into between a LED bare chip and a substrate, resulting in the formation of a gap therein.

When the phosphor layer is cured by heating with the above-mentioned gap remaining, air contained in the gap expands under heat and compresses the phosphor layer covering the LED bare chip, so that the phosphor layer may be deformed and a through-hole may be formed as a result of air leakage. This case causes the phosphor layer covering the LED bare chip to have a non-uniform thickness, leading to, for example, uneven chromaticity of output light and a decrease in luminous efficiency, which are problematic.

Furthermore, when a gap exists between a LED bare chip and a substrate, water is accumulated to cause ion migration across electrodes of the substrate and across p-n junctions of the LED bare chip as well as deterioration of the LED bare chip.

EP 1367655 A, US 2002/0070449 A1 and US 2003/0102481 A1 disclose luminescent light sources each comprising a light-emitting element, a substrate and a phosphor layer material containing a phosphor and a light-transmitting base material.

### Disclosure of Invention

With the foregoing in mind, it is an object of the present invention to provide a luminescent light source in which a gap between a light-emitting element such as a LED bare chip or the like and a substrate is eliminated even without the use of an underfill, a method for manufacturing the same, and a light-emitting apparatus using the luminescent light source.

A luminescent light source according to the present invention includes: a light-emitting element; a substrate including a conductor pattern; and a phosphor layer material containing a phosphor and a light-transmitting base material. In the luminescent light source, the light-emitting element is connected to the conductor pattern, and the phosphor layer material covers the light-emitting element. Further, the light-transmitting base material in the phosphor layer material is disposed between the light-emitting element and the substrate. The luminescent light source is characterised in that the phosphor layer material further contains an inorganic filler, and in that the inorganic filler in the phosphor layer material is disposed between the light-emitting element and the substrate.

Furthermore, a light-emitting apparatus according to the present invention includes a plurality of the above-described luminescent light sources.

Furthermore, a method for manufacturing a luminescent light source according to the present invention includes: a first process step of connecting a light-emitting element onto a substrate including a conductor pattern via a gap; a second process step of covering the light-emitting element connected onto the substrate with a phosphor layer material containing a phosphor and a light-transmitting base material in a low pressure atmosphere of a pressure lower than atmospheric pressure; and a third process step of allowing the light-transmitting base material contained in the phosphor layer material covering the light-emitting element to be filled between the light-emitting element and the substrate. The method is characterised in that the third step is performed in a higher pressure atmosphere than the low pressure atmosphere; in that the phosphor layer material further contains an inorganic filler; and in that the third process step further comprises allowing the inorganic filler contained in the phosphor layer material to be filled between the light-emitting element and the substrate.

According to the present invention, even without the use of an underfill, a gap between a light-emitting element and a substrate can be eliminated. Thus, a luminescent light source that prevents the deformation of a phosphor layer and the formation of a through-hole resulting from air leakage so as to achieve a uniform thickness of the phosphor layer, and a light-emitting apparatus using the same can be provided.

Furthermore, according to the present invention, since an underfill is not used, it is possible to reduce cycle time by eliminating the process of filling an underfill from the conventional processes and prevent peeling that occurs at an interface between an underfill and a phosphor layer. Thus, a practical method for manufacturing the luminescent light source according to the present invention can be provided.

### Brief Description of Drawings

FIG. 1 is a cross-sectional view showing an example of a method for manufacturing a luminescent light source according to the present invention.
FIG. 2 is a cross-sectional view showing the example of the method for manufacturing the luminescent light source according to the present invention.
FIG. 3 is a cross-sectional view showing the example of the method for manufacturing the luminescent light source according to the present invention.
FIG. 4 is a cross-sectional view showing the example of the method for manufacturing the luminescent light source according to the present invention.
FIG. 5 is a cross-sectional view showing an example of a luminescent light source according to the present invention.
FIG. 6 is a cross-sectional view showing another example of the method for manufacturing a luminescent light source according to the present invention.
FIG. 7 is a cross-sectional view showing another example of the method for manufacturing the luminescent light source according to the present invention.
FIG. 8 is a cross-sectional view showing another example of the method for manufacturing the luminescent light source according to the present invention.
FIG. 9 is a cross-sectional view showing another example of the method for manufacturing the luminescent light source according to the present invention.
FIG. 10 is a cross-sectional view showing still another example of the luminescent light source according to the present invention.
FIG. 11 is a cross-sectional view showing yet still another example of the luminescent light source according to the present invention.
FIG. 12 is a perspective view showing an example of a light-emitting apparatus according to the present invention.
FIG. 13 is an exploded perspective view showing the example of the light-emitting apparatus according to the present invention.
FIG. 14 is a perspective view of a table lamp type illumination apparatus as another example of the light-emitting apparatus using the luminescent light source according to the present invention.
FIG. 15 is a perspective view of a plate type image display as still another example of the light-emitting apparatus using the luminescent light source according to the present invention.
FIG. 16 is a perspective view of a segmented number display as yet still another example of the light-emitting apparatus using the luminescent light source according to the present invention.

### Description of the Invention

Hereinafter, the present invention will be described by way of embodiments with reference to the appended drawings. In the following embodiments, like parts are identified by the same reference characters, and duplicate descriptions thereof may be omitted.

### <Embodiment of the method for manufacturing a luminescent light source and the luminescent light source according to the present invention>

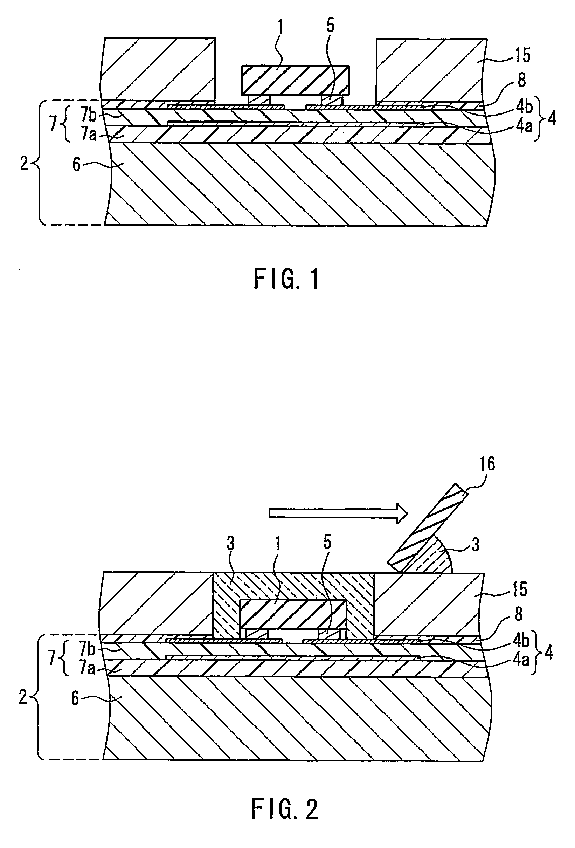

FIGs. 1 to 4 are cross-sectional views showing an example of the method for manufacturing a luminescent light source according to the present invention.

First, as shown in FIG. 1, using a bump 5, a light-emitting element 1 is connected to a conductor pattern 4b on a substrate 2 via a gap (first process step), and a mask 15 is disposed on a surface of the substrate 2 so as to enclose the light-emitting element 1.

The light-emitting element 1 is of a so-called single-sided electrode type, namely, has both a p-electrode and an n-electrode on its lower surface, and the p-electrode and the n-electrode are connected electrically to the conductor pattern 4b via the bump 5. The light-emitting element 1 is not limited particularly by a material, a structure or the like as long as it is a photoelectric transducer for converting electric energy into light, and as the light-emitting element 1, for example, a LED, a laser diode (LD), a surface-emitting LD, an inorganic electroluminescence (EL) element, and an organic EL element can be used.

The substrate 2 is a so-called metal base substrate and includes a resin film 8, two insulating layers 7a and 7b (referred to collectively as insulating layers 7), and a metal base 6 attached on a back surface of the insulating layer 7a. Conductor patterns 4a and 4b for feeding electric power to the light-emitting element 1 (referred to collectively as conductor patterns 4) are formed on surfaces of the insulating layers 7a and 7b, respectively. The conductor patterns 4a and 4b sandwich the insulating layer 7b therebetween and are connected electrically by means of, for example, a via hole (not shown). The metal base 6 has a function of reinforcing the insulating layers 7 and radiating heat generated when the light-emitting element 1 emits light.

The resin film 8 protects the conductor pattern 4b and secures insulation between the conductor pattern 4b and a reflective plate 9 (that will be described later). A material for the resin film 8 is not limited particularly as long as it maintains electrical insulation, and as the material, for example, a resist formed of a white epoxy resin in general use can be used. Herein, the resin film 8 is set to have a white color in order to allow light emitted from the light-emitting element 1 to be outputted efficiently to the exterior. Further, in the resin film 8, holes (window openings) are formed in portions corresponding respectively to the positions of the light-emitting elements 1. The holes are formed by, for example, removing the above-mentioned portions of the resin film after the resin film is formed first on the entire surface of the insulating layer 7b.

A material for the insulating layers 7 is not limited particularly as long as it maintains electrical insulation, and as the material, for example, a ceramic material, a glass epoxy material, and a thermosetting resin can be used. Further, the material further may contain an inorganic filler. As the thermosetting resin, for example, an epoxy resin can be used, and as the inorganic filler, for example, a silica filler and an alumina filler that have high thermal conductivity can be used.

The mask 15 is a mold for molding a phosphor layer material and has holes in portions corresponding respectively to the positions of the light-emitting elements 1 so that the light-emitting elements 1 are fitted respectively in the holes when the mask 15 is placed over the substrate 2.

In the above-described first process step, there is no particular limitation on a method of connecting the light-emitting element 1 to the substrate 2. That is, the method could be any general connection method of electrically connecting electrodes included in the light-emitting element 1 to the conductor patterns 4 included in the substrate 2, in which a gap is formed between the light-emitting element 1 and the substrate 2. The connection method using the bump 5 is particularly preferable in that there is no obstacle to light output in an irradiation direction of a luminescent light source.

In this embodiment, in order to enable higher-density mounting of the light-emitting element 1, the substrate 2 has a multilayer structure using the two insulating layers 7a and 7b. However, if there is no need to have the multilayer structure, a single layer structure using one insulating layer or a multilayer structure of three or more layers may be employed. Further, the substrate 2 is not limited by the above-mentioned materials and the like.

Next, as shown in FIG. 2, in a low pressure atmosphere of a pressure lower than atmospheric pressure, using a squeegee 16, the light-emitting element 1 connected to the substrate 2 is covered with a phosphor layer material 3 (second process step).

The above-mentioned low pressure atmosphere is, for example, an atmosphere of a pressure of 20 Pa to 100 Pa.

The phosphor layer material 3 is not limited particularly as long as it contains at least a phosphor and a light-transmitting base material and allows a three-dimensional shape to be maintained so as to cover the light-emitting element 1.

The above-mentioned phosphor is not limited particularly as long as it at least is excited by light emitted by the light-emitting element 1 to emit light. As the phosphor, for example, a garnet phosphor activated with Ce³⁺ (Y₃Al₅O₁₂ : Ce³⁺ or the like), an alkaline-earth metal orthosilicate phosphor activated with Eu²⁺ ((Sr, Ba)₂SiO₄: Eu²⁺ or the like), a Ca-α SIALON phosphor activated with Eu²⁺, and a thiogallate phosphor activated with Eu²⁺ (CaGa₂S₄: Eu²⁺ or the like) can be used. These phosphors may be used alone or in a combination of a plurality of types.

There is no particular limitation on a wavelength of excited light emitted by the light-emitting element 1, and for example, blue light having an emission peak in the wavelength region of 420 nm to 470 nm and near-ultraviolet light having an emission peak in the wavelength region of 350 nm to 410 nm can be used. Specifically, it also is possible to obtain a luminescent light source that emits white light by allowing a red phosphor, a green phosphor and a blue phosphor to be excited using a light-emitting element that emits near-ultraviolet light having an emission peak in the wavelength region of 350 nm to 410 nm.

The above-mentioned light-transmitting base material is not limited particularly as long as it is a light-transmitting material that has a property of being cured by the application of heat, ultraviolet light or the like, or an inorganic transparent material such as glass or the like in which at least a phosphor can be dispersed. As the light-transmitting base material, for example, a resin and low-melting glass can be used. It is more preferable that the light-transmitting base material has a spectral transmittance of 70% or higher at an emission peak wavelength of the light-emitting element 1. Further, it is more preferable to use as the resin, at least one selected from an epoxy resin, a silicone resin and a fluorocarbon resin since these resins have an excellent light-transmitting property. Among these, a silicone resin is used even more preferably since it has such large elasticity so as to be capable of protecting a light-emitting element from an external force and exhibits excellent heat resistance and light resistance.

In the above-described second process step, a method of covering the light-emitting element 1 is not limited particularly to the so-called screen printing method using a mask and a squeegee.

In the manufacturing method according to this embodiment, the phosphor layer material 3 further contains an inorganic filler. The inorganic filler is not limited particularly as long as it is used generally as a filler and has a high light transmittance, and can be formed of, for example, silicon dioxide, alumina, aluminum nitride, silicon nitride, titanium oxide, or magnesium oxide. Among these, silicon dioxide is preferable as a viscosity adjusting material for a phosphor layer before being cured since it has a high spectral transmittance and an effect of increasing viscosity. Silicon dioxide used as a viscosity adjusting material has a particle diameter of primary particles as minute as about 15 nm and a mean particle diameter of not more than 100 nm. Moreover, in the case where silicon dioxide having a mean particle diameter of 100 nm to 10 µm further is used in addition to the primary particles, by a thermal conduction effect of the silicon dioxide, heat generated by a LED bare chip can be released efficiently to the exterior, and at the same time, a thermal expansion/contraction coefficient of a phosphor layer is decreased, which are effective in suppressing stress to be exerted on the LED bare chip. Particularly, in the case of using an inorganic filler having a mean particle diameter of 100 nm to 10 µm and more preferably of 100 nm to 5 µm, the filler is filled into a clearance of about 10 µm between a LED bare chip and a substrate, and thus the above-described effect can be obtained efficiently

Furthermore, in the case where silicon nitride, sapphire, zirconia or the like that has a high refractive index is used for the inorganic filler, a refractive index difference from a LED bare chip is decreased, thereby allowing light to be outputted more easily from the LED bare chip to the exterior.

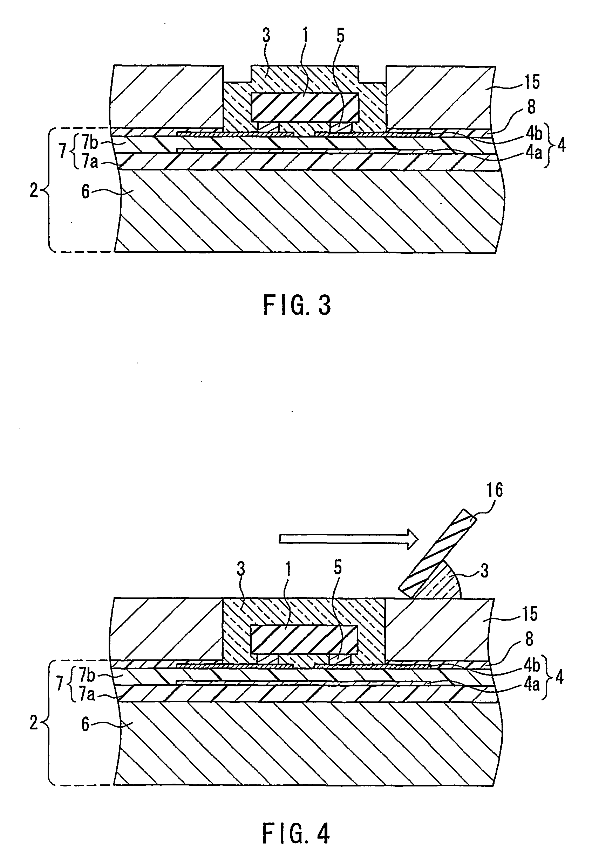

Next, as shown in FIG. 3, by raising the pressure used in the second process step to obtain a high pressure atmosphere, the phosphor layer material 3 covering the light-emitting element 1 is allowed to be filled into a gap between the light-emitting element 1 and the substrate 2 (third process step). At this time, at a surface of the phosphor layer material 3, a concaved portion is formed as a result of a portion of the phosphor layer material 3 being filled into the gap (hereinafter, this concaved portion is referred to as a concave portion).

The above-mentioned high pressure atmosphere is, for example, an atmosphere of a pressure of 10 kPa to 90 kPa. That is, by raising the pressure used in the second process step, due to a vacuum differential pressure, the phosphor layer material 3 is allowed to be filled into the gap between the light-emitting element 1 and the substrate 2.

Herein, a filled state is not limited to a state in which the gap is filled completely. It is sufficient that the gap is filled, for example, to such an extent that the deformation of the phosphor layer material 3 and the formation of a through-hole are not caused when the luminescent light source is used. Specifically, for example, not less than 70% by volume of the gap between the light-emitting element 1 and the substrate 2 should be filled with the phosphor layer material 3.

Furthermore, it is sufficient that the above-described portion of the phosphor layer material 3 filled between the light-emitting element 1 and the substrate 2 contains at least the light-transmitting base material, and in the case where a gap between the light-emitting element 1 and the substrate 2 has a height smaller than the particle diameter of the above-described phosphor, the phosphor may not be filled.

In the manufacturing method according to this embodiment, as the phosphor layer material 3 contains an inorganic filler in the above-described second process step, the portion of the phosphor layer material 3 filled into the gap between the light-emitting element 1 and the substrate 2 also may contain the inorganic filler. In the case where the inorganic filler is contained between the light-emitting element 1 and the substrate 2, stress exerted when the light-emitting element 1 and the substrate 2 are bonded together is reduced, and heat generated in the light-emitting element 1 is radiated efficiently to the substrate, which is more preferable.

Next, as shown in FIG. 4, while maintaining the above-mentioned high pressure atmosphere used in the third process step, using the squeegee 16, an extra portion of the phosphor layer material 3 is added to the concave portion on the surface of the phosphor layer material 3, and then the mask 15 is removed in an atmospheric pressure atmosphere.

The process of adding the extra portion of the phosphor layer material 3 is performed so that the surface of the phosphor layer material 3 is flattened and the thickness of the phosphor layer material 3 is made more uniform. However, this process can be omitted when there is no need for it because, for example, the concave portion is extremely small.

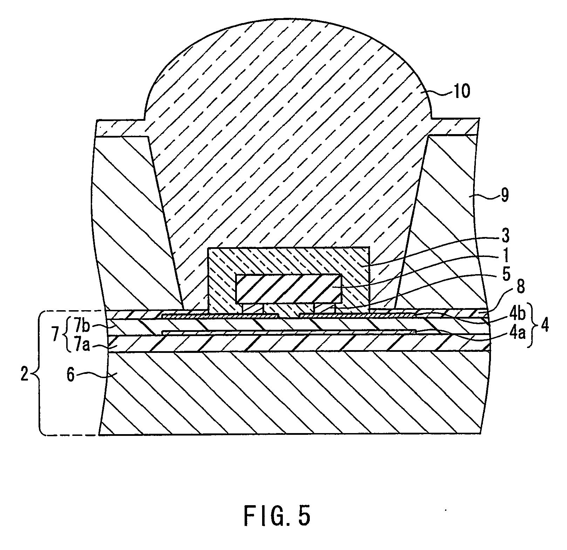

Finally, as shown in FIG. 5, the phosphor layer material 3 is cured first, and the reflective plate 9 subsequently is mounted on the surface of the substrate 2. After that, a lens plate 10 is formed so as to cover the phosphor layer material 3 and the reflective plate 9. Thus, the luminescent light source according to this embodiment is completed.

The phosphor layer material 3 is cured as described above by a method that is determined by a property of the phosphor layer material 3, particularly, a property of the light-transmitting base material. Examples of the method include heating and light irradiation. For example, in the case of using a silicone resin as the light-transmitting base material, the method could be heating performed at 135°C for 60 minutes.

In the reflective plate 9, reflection holes are provided so as to correspond respectively to the mounting positions of the light-emitting elements 1, and the reflective plate 9 can be formed of, for example, a metal plate of aluminum or the like, a white resin, ceramic, of a resin whose surface is plated. In the case of using a metal plate of aluminum for the reflective plate 9, for example, when the metal plate is subjected to anodic oxidation and an oxide film is formed thereon, the reflectance can be improved, and electrical insulation also can be secured, which is more preferable.

The lens plate 10 includes a convex lens that protrudes in a hemispherical shape so as to correspond to the mounting position of each of the light-emitting elements 1, and is formed by, for example, a transfer molding method, a casting method, or an injection molding method. For the lens plate 10, a light-transmitting material such as, for example, an epoxy resin, glass, a silicone resin, a polycarbonate resin, a polystyrene resin, non-crystalline polyester, non-crystalline polyolefin, an acrylic resin, a cycloolefin resin, or a fluorocarbon resin can be used.

Although only one luminescent light source is shown in the manufacturing method according to this embodiment, it also is possible to manufacture a plurality of the same type of luminescent light sources at the same time.

In the luminescent light source according to the present invention, the phosphor layer material 3 can be filled into a gap between the light-emitting element 1 and the substrate 2. Thus, for example, the deformation of the phosphor layer material 3 and the formation of a through-hole resulting from air leakage can be prevented, thereby allowing the phosphor layer material 3 to have a uniform thickness.

### <Another embodiment of the method for manufacturing a luminescent light source according to the present invention>

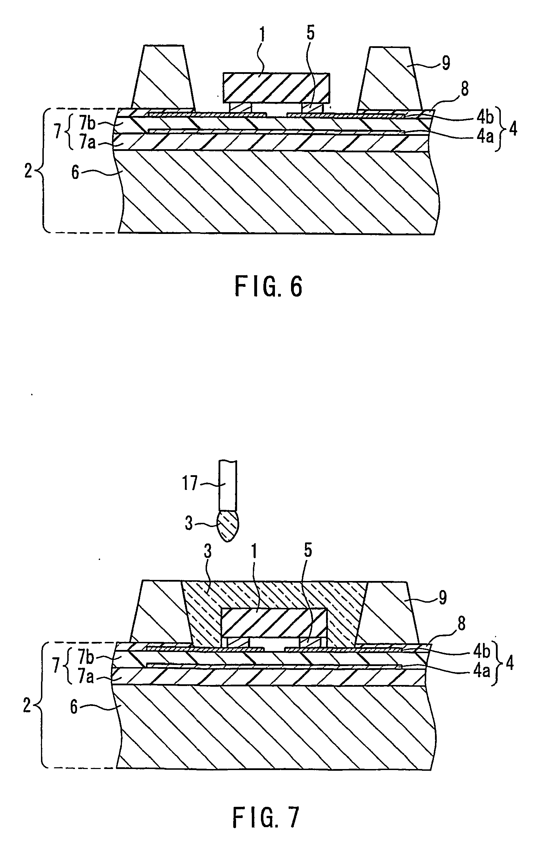

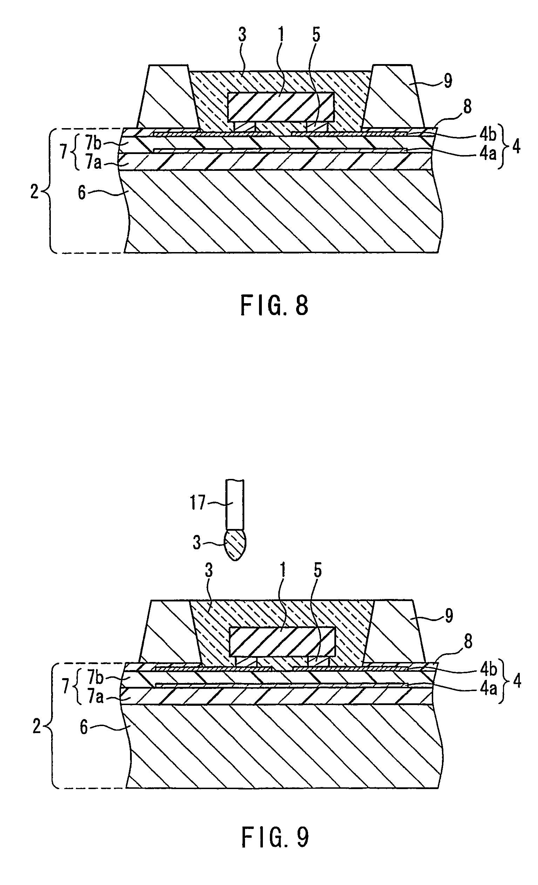

FIGs. 6 to 9 are cross-sectional views showing processes in another example of the method for manufacturing a luminescent light source according to the present invention. In FIGs. 6 to 9, like parts are identified by the same reference characters as in FIGs. 1 to 4, and duplicate descriptions thereof are omitted. Further, each of FIGs. 7 and 9 shows a dispenser 17 but not in cross section.

First, as shown in FIG. 6, using a bump 5, a light-emitting element 1 is connected to a conductor pattern 4b on a substrate 2 via a gap (first process step), and a cup-like reflective plate 9 is disposed on a surface of the substrate 2 so as to enclose the light-emitting element 1. In the reflective plate 9, reflection holes are provided so as to correspond respectively to the mounting positions of the light-emitting elements 1.

Next, as shown in FIG. 7, in a low pressure atmosphere of a pressure lower than atmospheric pressure, using a dispenser 17, a phosphor layer material 3 is filled by potting into the reflection hole of the reflective plate 9 so that the light-emitting element 1 connected to the substrate 2 is covered with the phosphor layer material 3 (second process step).

The above-mentioned low pressure atmosphere is, for example, an atmosphere of a pressure of 20 Pa to 100 Pa.

Next, as shown in FIG. 8, by raising the pressure used in the second process step to obtain a high pressure atmosphere, the phosphor layer material 3 covering the light-emitting element 1 is allowed to be filled into a gap between the light-emitting element 1 and the substrate 2 (third process step). At this time, a surface of the phosphor layer material 3 is lowered in level as a result of a portion of the phosphor layer material 3 being filled into the gap.

The above-mentioned high pressure atmosphere is, for example, an atmosphere of a pressure of 10 kPa to 90 kPa. That is, by raising the pressure used in the second process step, due to a vacuum differential pressure, the phosphor layer material 3 is allowed to be filled into the gap between the light-emitting element 1 and the substrate 2.

Next, as shown in FIG. 9, while maintaining the above-mentioned high pressure atmosphere used in the third process step, using the dispenser 17, an extra portion of the phosphor layer material 3 is added to the surface of the phosphor layer material 3.

Finally, the phosphor layer material 3 is cured, and subsequently, a lens plate is formed so as to cover the phosphor layer material 3 and the reflective plate 9. Thus, as shown in FIG. 5 mentioned above, a luminescent light source according to this embodiment is completed.

### <Another embodiment of the luminescent light source according to the present invention>

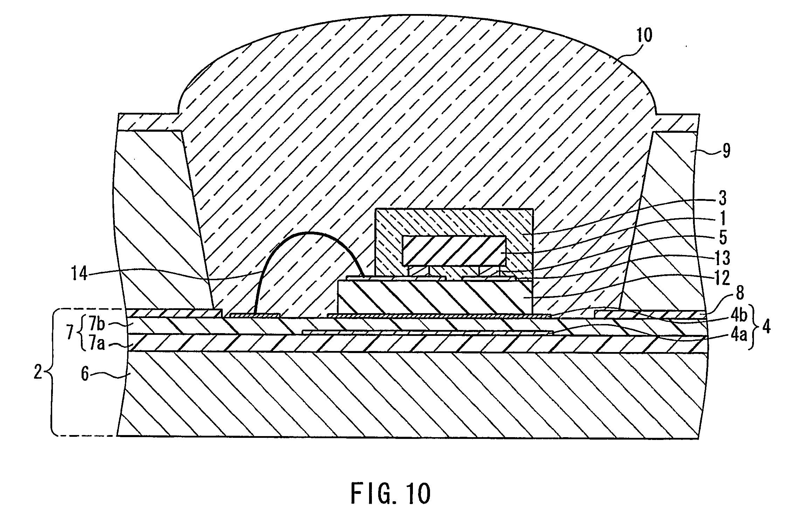

FIG. 10 is a cross-sectional view showing still another example of the luminescent light source according to the present invention. In FIG. 10, like constituent members bear the same reference characters as those of the luminescent light source shown in FIG. 5, and duplicate descriptions thereof are omitted.

A luminescent light source according to this embodiment has the same configuration as that of the luminescent light source shown in FIG. 5 except that a sub-substrate 12 formed of a sub-mount further is provided.

As shown in FIG. 10, the luminescent light source includes a light-emitting element 1, a substrate 2 including conductor patterns 4, a phosphor layer material 3 containing a phosphor and a light-transmitting base material, a reflective plate 9, and a lens plate 10. The luminescent light source further includes the sub-substrate 12 with a conductor pattern 13 provided on its surface, and a wire 14.

The light-emitting element 1 is disposed on the conductor pattern 13 via a bump 5 and connected electrically to the conductor pattern 13. The phosphor layer material 3 is disposed so as to cover the light-emitting element 1 and a portion of the conductor pattern 13. The phosphor layer material 3 further is filled between the light-emitting element 1 and the sub-substrate 12. The sub-substrate 12 is disposed on a conductor pattern 4b on the substrate 2. Further, the conductor pattern 13 is connected to the conductor pattern 4b by means of the wire 14. Moreover, the reflective plate 9 and the lens plate 10 are disposed on the substrate 2.

The sub-substrate 12 is die-bonded onto the conductor pattern 4b on the substrate 2 by a general method such as, for example, a method using a conductive paste. Further, a portion of the conductor pattern 13 on the sub-substrate 12 is connected to the conductor pattern 4b using the wire 14. This allows the light-emitting element 1 to be connected electrically to the substrate 2.

There is no particular limitation on the wire 14, and any type of wire that is used generally for wire bonding such as, for example, a gold wire can be used as the wire 14.

A structure of the sub-substrate 12, the light-emitting element 1 and the phosphor layer material 3 is not limited to the above-described structure. Further, although the light-emitting element 1 of the single-sided electrode type with electrodes provided on its back surface is used herein, the light-emitting element 1 also can be of a two-sided electrode type in which electrodes are provided respectively on front and back surfaces.

The luminescent light source according to this embodiment has this configuration, and thus in addition to the above-described effects, the following effects are attained. First, since the light-emitting element 1 is connected to the sub-substrate 12 beforehand, the light-emitting element 1 mounted on the sub-substrate 12 can be inspected to see that, for example, it operates properly, before being connected to the substrate 2. By performing such an inspection beforehand, for example, an effect can be obtained that the manufacturing yield of the luminescent light source can be improved. Further, for example, an effect also is provided that a luminescent light source that outputs light of a more desirable color can be used selectively in place of a luminescent light source that hardly outputs light of a uniform color.

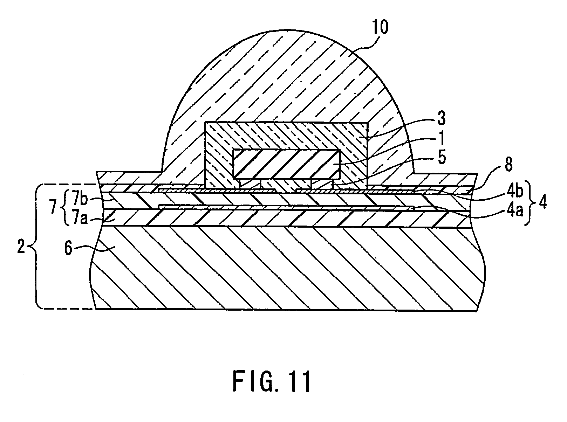

FIG. 11 is a cross-sectional view showing yet still another example of the luminescent light source according to the present invention. In FIG. 11, like constituent members bear the same reference characters as those of the luminescent light source shown in FIG. 5, and duplicate descriptions thereof are omitted.

A luminescent light source according to this embodiment has the same configuration and effects as those of the luminescent light source shown in FIG. 5 except that the reflective plate 9 is not provided.

As shown in FIG. 11, the luminescent light source includes a light-emitting element 1, a substrate 2 including conductor patterns 4, a phosphor layer material 3 containing a phosphor and a light-transmitting base material, and a lens plate 10.

The light-emitting element 1 is connected to the substrate 2. The phosphor layer material 3 is disposed so as to cover the light-emitting element 1 and a portion of a conductor pattern 4b. The phosphor layer material 3 further is filled between the light-emitting element 1 and the substrate 2. Moreover, the lens plate 10 is disposed on the substrate 2. The lens plate 10 covers the light-emitting element 1 and the phosphor layer material 3 to form a convex lens having a hemispherical shape.

### <Embodiment of the light-emitting apparatus according to the present invention>

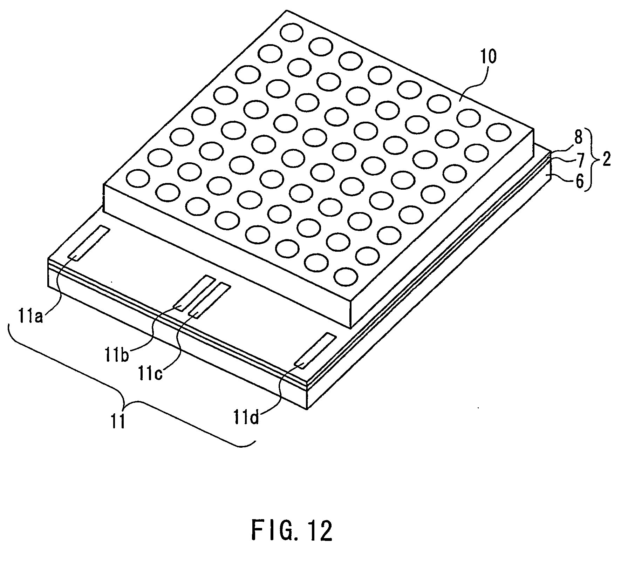

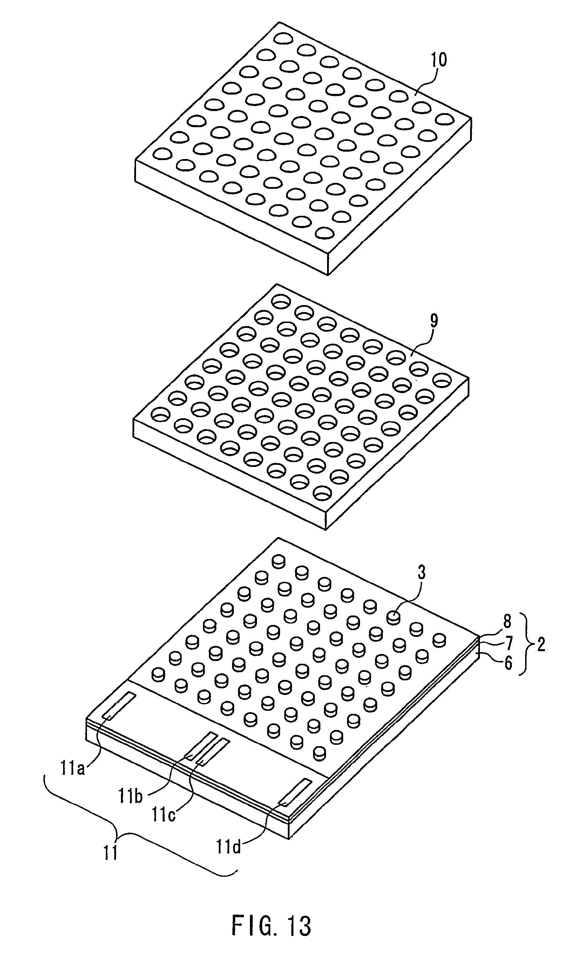

FIG. 12 is a perspective view showing an example of the light-emitting apparatus using the luminescent light source according to the present invention. Further, FIG. 13 is an exploded perspective view of the light-emitting apparatus. In FIGs. 12 and 13, like constituent members bear the same reference characters as those of the luminescent light source shown in FIG. 5, and duplicate descriptions thereof are omitted.

The light-emitting apparatus according to this embodiment has a configuration using a plurality of the luminescent light sources as shown in FIG. 5 and provides the same effects as those of the luminescent light source shown in FIG. 5.

As shown in FIG. 13, the light-emitting apparatus includes a substrate 2 with pieces of a phosphor layer material 3 respectively covering 64 light-emitting elements 1 as described above (FIG. 5) provided on its surface, connection terminals 11 and a reflective plate 9 that are disposed on a surface of the substrate 2, and a lens plate 10 that covers the reflective plate 9 and the phosphor layer material 3.

The connection terminals 11 are formed on the surface of the substrate 2 and used to feed electric power to the light-emitting elements 1 by means of the above-described conductor patterns 4 (FIG. 5). Herein, 32 light-emitting elements 1 are connected in series using the above-described conductor pattern 4b (FIG. 5) and further are connected to connection terminals 11a and 11b. Further, similarly, the remaining 32 light-emitting elements 1 are connected to connection terminals 11c and 11d.

The reflective plate 9 reflects light emitted from the light-emitting elements 1 in a predetermined direction, and in the reflective plate 9, 64 reflection holes are provided so as to correspond respectively to the disposed positions of the pieces of the phosphor layer material 3.

The lens plate 10 converges reflected light to a desired direction, and in the lens plate 10, 64 convex lenses respectively protruding in a hemispherical shape are provided so as to correspond respectively to the disposed positions of the pieces of the phosphor layer material 3.

Each of the pieces of the phosphor layer material 3 is formed in a columnar shape so that in each piece, a portion for radiating light emitted from the light-emitting element 1 to the exterior can be restricted, and so that when seen as a single element, the light-emitting element 1 can be regarded as functioning more like a point light source.

### <Another embodiment of the light-emitting apparatus according to the present invention>

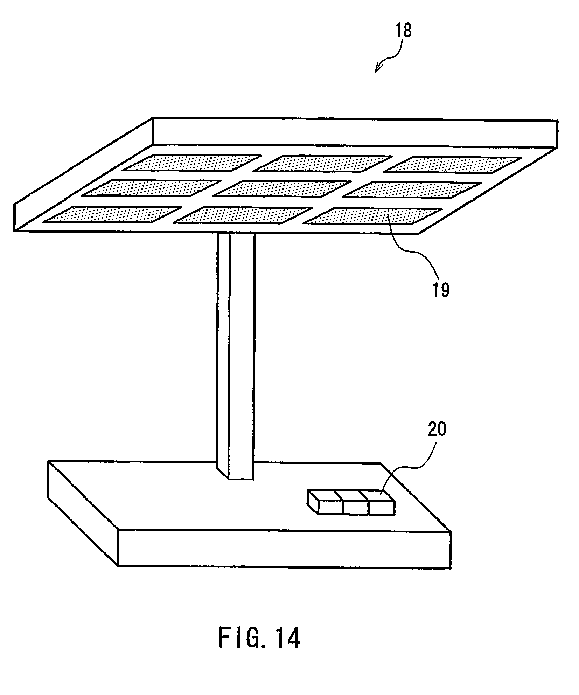

FIG. 14 is a perspective view of a table lamp type illumination apparatus as another example of the light-emitting apparatus using the luminescent light source according to the present invention. As shown in FIG. 14, in an illumination apparatus 18, a light-emitting portion 19 is provided that has the luminescent light source according to the present invention, and ON/OFF control and light amount control can be performed by means of a switch 20.

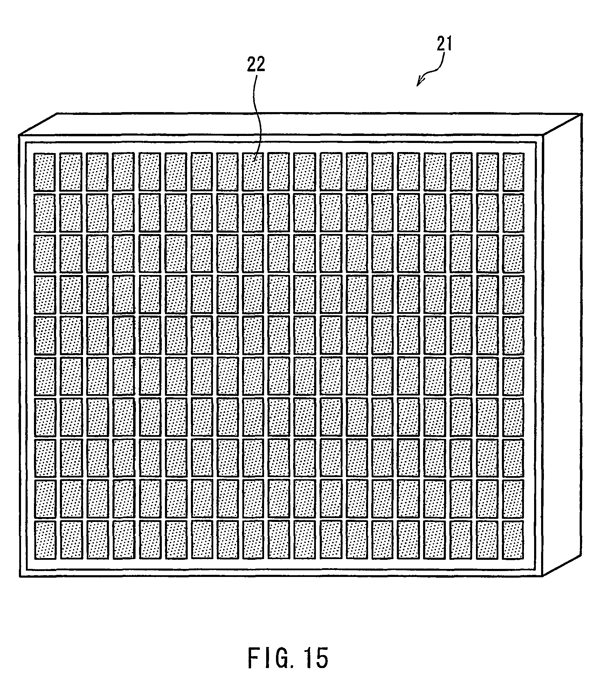

FIG. 15 is a perspective view of a plate type image display as still another example of the light-emitting apparatus using the luminescent light source according to the present invention. In FIG. 15, an image display 21 includes a light-emitting portion 22 that has the luminescent light source according to the present invention.

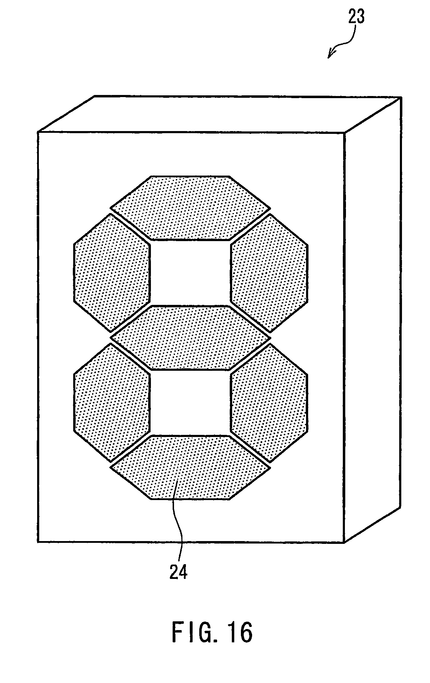

FIG. 16 is a perspective view of a segmented number display as yet still another example of the light-emitting apparatus using the luminescent light source according to the present invention. In FIG. 16, a number display 23 includes a light-emitting portion 24 that has the luminescent light source according to the present invention.

Hereinafter, the present invention will be described more specifically by way of examples.

### (Example)

In this example, as a light-emitting apparatus, a card type light emitting apparatus that has the same configuration as that of the light-emitting apparatus shown in FIGs. 12 and 13 and includes 64 LED bare chips was produced. Further, the light-emitting apparatus according to this example is configured by using a plurality of luminescent light sources of the same configuration as that of the luminescent light source shown in FIG. 5. Accordingly, reference can be made to FIG. 5 as a partial cross-sectional view for this example and to FIGs. 1 to 4 as partial cross-sectional views showing a manufacturing method according to this embodiment.

Initially, a substrate 2 was produced in the following manner. First, an epoxy resin containing an inorganic filler and copper foil (thickness: 10 µm) were laminated on a metal base 6 formed of an aluminum plate (size: 3 cm by 3 cm, thickness: 1 mm) and subjected to thermocompression to form an insulating layer 7a (thickness: 100 µm). After that, the copper foil was etched so that a desired conductor pattern 4a was formed. On a body thus obtained, an epoxy resin containing an inorganic filler and copper foil (thickness: 10 µm) further were laminated and subjected to thermocompression to form an insulating layer 7b (thickness: 100 µm). Next, the copper foil was etched so that a desired conductor pattern 4b was formed, and the conductor pattern 4a was connected electrically to the conductor pattern 4b by means of a via hole. Finally, as shown in FIG. 1, after a white epoxy resin was applied, window openings were formed in the white epoxy resin in mounting positions of the LED bare chips so that a resin film 8 was formed, and thus the substrate 2 was completed.

Next, the LED bare chips, namely, the light-emitting elements 1 were connected to the substrate 2 and covered with a phosphor layer material 3 in the following manner. First, the LED bare chips (approximately 300 µm square, height: approximately 100 µm, emission peak wavelength: 460 nm) were placed on the conductor pattern 4b on the substrate 2 via a bump 5. The bump 5 was melted by the application of ultrasonic waves, so that the LED bare chips were connected to the conductor pattern 4b. Subsequently, the LED bare chips connected to the substrate 2 were covered with the phosphor layer material 3 by the screen printing method.

The LED bare chips were covered with the phosphor layer material 3 in the following manner. First, as shown in FIG. 1, a mask 15 was disposed on a surface of the substrate 2. The mask 15 is a mold in which the phosphor layer material 3 is to be filled and is structured to have holes in portions corresponding respectively to the positions of the LED bare chips so that the LED bare chips are fitted respectively in the holes when the mask 15 is placed over the substrate 2.

Next, in a low pressure atmosphere of a pressure of 30 Pa, as shown in FIG. 2, using a squeegee 16, the LED bare chips were covered with the phosphor layer material 3 by the screen printing method. The phosphor layer material 3 is formed of a light-transmitting base material of a silicone resin in which a phosphor and an inorganic filler are added. In this case, the phosphor is formed of an alkaline-earth metal orthosilicate phosphor activated with Eu²⁺ ((Sr, Ba)₂SiO₄ : Eu²⁺), which is dehydrated using a drying furnace, and the inorganic filler is formed of silicon dioxide (SiO₂) dehydrated using the drying furnace. Further, the phosphor layer material 3 was stirred in a low pressure atmosphere of a pressure of 667 Pa (= 5 Torr) before use so that air bubbles were squeezed out. By the stirring in the low pressure atmosphere, air bubbles remaining in the phosphor layer material 3 after being applied by screen printing can be reduced further.

Subsequently, as shown in FIG. 3, in a high pressure atmosphere of a pressure of 65 kPa, due to a vacuum differential pressure, the phosphor layer material 3 was allowed to be filled between each of the LED bare chips and the substrate 2. Each of the LED bare chips was at a distance of not less than 10 µm in a height direction from the substrate 2, and thus not only the light-transmitting base material but also the phosphor and the inorganic filler were filled into a gap between each of the LED bare chips and the substrate 2. At this time, at a surface of each piece of the phosphor layer material 3, a concaved portion was formed as a result of a portion of the phosphor layer material 3 being filled into the gap.

Moreover, as shown in FIG. 4, while maintaining the high pressure atmosphere (pressure: 65 kPa), using the squeegee 16, an extra portion of the phosphor layer material 3 was added to the concave portion on the surface of each piece of the phosphor layer material 3, and the surface was flattened. Next, in an atmospheric pressure atmosphere (100 kPa), the mask 15 was removed, and heating further was performed at 135°C for 60 minutes so that the silicone resin was cured, and thus a phosphor layer was formed.

Subsequently, the light-emitting apparatus according to this example was completed in the following manner. First, after a reflective plate 9 formed of aluminum subjected to anodic oxidation was mounted on the resin film 8, a lens plate 10 formed of an epoxy resin was formed so as to cover the phosphor layer material 3 and the reflective plate 9. Further, at the same time that the substrate was produced, connection terminals 11 for feeding electric power to the light-emitting elements 1 via the conductor patterns 4 were formed on the surface of the substrate 2.

In the reflective plate 9, reflection holes having the shape of a reverse conical tube are provided so as to correspond respectively to the LED bare chips. Further, the reflective plate 9 was mounted using an adhesive. Specifically, the adhesive was applied to a back surface of the reflective plate 9, and the reflective plate 9 was mounted so that the phosphor layer material 3 entered the reflection holes of the reflective plate 9.

The lens plate 10 was formed in the following manner. That is, a mold for molding a lens plate (not shown) was disposed on the substrate 2 on which the above-described reflective plate 9 was mounted, and the epoxy resin was injected into the mold.

The conductor pattern 4b was formed so that every 32 LED bare chips were connected in series and connected to either of a pair of connection terminals 11a and 11b and a pair of connection terminals 11c and 11d.

The card type light-emitting apparatus including 64 LED bare chips according to this example was obtained by the above-described processes.

### (Comparative Example)

Alight-emitting apparatus according to this comparative example was manufactured under the same conditions as those for the light-emitting apparatus according to Example 1 except that LED bare chips were covered with a phosphor layer material 3 under atmospheric pressure at all times.

In the following description, a comparison is made between the light-emitting apparatus according to the Example and the light-emitting apparatus according to Comparative Example.

With respect to each of these light-emitting apparatus, side faces of 100 phosphor layers (one LED bare chip was assumed to have one phosphor layer) were examined using a metallurgical microscope manufactured by Olympus Corporation. As a result, in the light-emitting apparatus according to the Comparative Example, among the phosphor layers, 65 had a though-hole resulting from air leakage and 35 exhibited a trace of the expansion of an air layer, while in the light-emitting apparatus according to the Example, neither a through-hole nor a trace of expansion was observed. Conceivably, such a through-hole and trace of expansion result from the expansion of air existing between each LED bare chip and a substrate that is caused when a phosphor layer material is cured by heating, constituting one factor leading to uneven chromaticity of output light. In summary, in the light-emitting apparatus according to the Example of the present invention, neither a through-hole nor a trace of expansion was observed, which is a significant difference from the Comparative Example.

Furthermore, a minute forward current was passed through each of these light-emitting apparatuses via connection terminals to examine a decrease in forward voltage. Specifically, with respect to each of the light-emitting apparatuses according to the Example and Comparative Example, in which every 32 LED bare chips were connected in series, after an electric current of 40 mA was passed under constant temperature and humidity of 60°C and a relative humidity of 95% for 1000 hours, an electric current of 10 pA was passed and a voltage was measured. As a result, in the light-emitting apparatus according to the Comparative Example, a voltage was decreased from 80 V to 75 V, while in the light-emitting apparatus according to the Example, there occurred no decrease in voltage. Conceivably, such a decrease in voltage with time is attributable to water or the like accumulated in a gap inside a luminescent light source, particularly, a gap between each of the LED bare chips and the substrate. The accumulation of water or the like constitutes one factor leading to ion migration. In summary, in the light-emitting apparatus according to the Example of the present invention, a decrease in voltage with time is not caused, which is a significant difference from the Comparative Example.

### Industrial Applicability

As described in the foregoing discussion, the present invention can provide a luminescent light source that has no gap between a light-emitting element and a substrate, thereby obtaining output light with even chromaticity and achieving an improvement in luminous efficiency, a method for manufacturing the same, and a light-emitting apparatus using the luminescent light source.

## Claims

1. A luminescent light source, comprising:
a light-emitting element (1);
a substrate (2) including a conductor pattern (4); and
a phosphor layer material (3) containing a phosphor and a light-transmitting base material,
the light-emitting element (1) being connected to the conductor pattern (4), and the phosphor layer material (3) covering the light-emitting element (1),
wherein the light-transmitting base material in the phosphor layer material (3) is disposed between the light-emitting element (1) and the substrate (2),
**characterised in that** the phosphor layer material (3) further contains an inorganic filler, and **in that** the inorganic filler in the phosphor layer material (3) is disposed between the light-emitting element (1) and the substrate (2).

2. The luminescent light source according to claim 1,
wherein the phosphor is not disposed in the phosphor layer material (3) between the light-emitting element (1) and the substrate (2). ,

3. The luminescent light source according to claim 1,
wherein the light-emitting element (1) is connected to the conductor pattern (4) using a bump (5).

4. The luminescent light source according to claim 1,
wherein the light-transmitting base material has a property of having a spectral transmittance of 70% or higher at an emission peak wavelength of the light-emitting element (1).

5. The luminescent light source according to claim 1,
wherein the light-transmitting base material is at least one selected from an epoxy resin, a silicone resin and a fluorocarbon resin.

6. The luminescent light source according to claim 1,
wherein the inorganic filler is formed of at least one selected from silicon dioxide, alumina, aluminum nitride, silicon nitride, titanium oxide, and magnesium oxide.

7. A light-emitting apparatus comprising a plurality of luminescent light sources as claimed in any preceding claim.

8. A method for manufacturing a luminescent light source, comprising:
a first process step of connecting a light-emitting element (1) onto a substrate (2) including a conductor pattern (4) via a gap;
a second process step of covering the light-emitting element (1) connected onto the substrate (2) with a phosphor layer material (3) containing a phosphor and a light-transmitting base material in a low pressure atmosphere of a pressure lower than atmospheric pressure; and
a third process step of allowing the light-transmitting base material contained in the phosphor layer material (3) covering the light-emitting element (1) to be filled between the light-emitting element (1) and the substrate (2);
**characterised in that** the third step is performed in a higher pressure atmosphere than the low pressure atmosphere;
**in that** the phosphor layer material (3) further contains an inorganic filler; and
**in that** the third process step further comprises allowing the inorganic filler contained in the phosphor layer material (3) to be filled between the light-emitting element (1) and the substrate (2).

9. The method according to claim 8,
wherein the phosphor contained in the phosphor layer material (3) is not filled between the light-emitting element (1) and the substrate (2).

10. The method according to claim 8, further comprising, after the third process step, a process step of adding an extra portion of the phosphor layer material (3) to the phosphor layer material (3) covering the light-emitting element (1).

11. The method according to claim 8,
wherein the second process step is performed in a low pressure atmosphere of a pressure of 20 Pa to 100 Pa, and the third process step is performed in a high pressure atmosphere of a pressure of 10 kPa to 90 kPa.

12. The method according to claim 8,
wherein in the first process step, the light-emitting element (1) is connected to the substrate (2) using a bump (5).

## Patentansprüche

1. Lumineszente Lichtquelle, mit:
einem lichtemittierenden Element (1);
einem Substrat (2), das ein Leitermuster (4) aufweist; und
einem Phosphorschichtmaterial (3), das Phosphor und ein Lichtdurchlass-Basismaterial enthält,
wobei das lichtemittierende Element (1) mit dem Leitermuster (4) verbunden ist und das Phosphorschichtmaterial (3) das lichtemittierende Element (1) abdeckt,
wobei das Lichtdurchlass-Basismaterial in dem Phosphorschichtmaterial (3) zwischen dem lichtemittierenden Element (1) und dem Substrat (2) angeordnet ist,
**dadurch gekennzeichnet, dass** das Phosphorschichtmaterial (3) ferner einen anorganischen Füllstoff enthält und dass der anorganische Füllstoff in dem Phosphorschichtmaterial (3) zwischen dem lichtemittierenden Element (1) und dem Substrat (2) angeordnet ist.

2. Lumineszente Lichtquelle nach Anspruch 1,
wobei der Phosphor nicht in dem Phosphorschichtmaterial (3) zwischen dem lichtemittierenden Element (1) und dem Substrat (2) angeordnet ist.

3. Lumineszente Lichtquelle nach Anspruch 1,
wobei das lichtemittierende Element (1) mit dem Leitermuster (4) unter Verwendung eines Höckers (5) verbunden ist.

4. Lumineszente Lichtquelle nach Anspruch 1,
wobei das Lichtdurchlass-Basismaterial die Eigenschaft besitzt, bei einer Emissionsspitzen-Wellenlänge des lichtemittierenden Elements (1) einen spektralen Durchlassgrad von 70 % oder mehr zu haben.

5. Lumineszente Lichtquelle nach Anspruch 1,
wobei das Lichtdurchlass-Basismaterial aus Epoxidharz und/oder Silikonharz und/oder Fluorkohlenstoffharz gewählt ist.

6. Lumineszente Lichtquelle nach Anspruch 1,
wobei der anorganische Füllstoff aus wenigstens einem der Materialien gebildet ist, die aus Siliciumdioxid, Aluminiumoxid, Aluminiumnitrid, Siliciumnitrid, Titanoxid und Magnesiumoxid gewählt sind.

7. Lichtemittierende Vorrichtung, die mehrere lumineszente Lichtquellen nach einem vorhergehenden Anspruch enthält.

8. Verfahren für die Herstellung einer lumineszenten Lichtquelle, das umfasst:
einen ersten Prozessschritt zum Anschließen eines lichtemittierenden Elements (1) auf einem Substrat (2), das ein Leitermuster (4) enthält, über einen Spalt;
einen zweiten Prozessschritt zum Abdecken des lichtemittierenden Elements (1), das mit dem Substrat (2) verbunden ist, mit einem Phosphorschichtmaterial (3), das Phosphor und ein Lichtdurchlass-Basismaterial enthält, in einer Niederdruckatmosphäre mit einem Druck, der niedriger als der Atmosphärendruck ist; und
einen dritten Prozessschritt, um zuzulassen, dass das Lichtdurchlass-Basismaterial, das in dem Phosphorschichtmaterial (3) enthalten ist, das das lichtemittierende Element (1) abdeckt, zwischen das lichtemittierende Element (1) und das Substrat (2) gefüllt wird;
**dadurch gekennzeichnet, dass** der dritte Schritt in einer Atmosphäre mit höherem Druck als in der Niederdruckatmosphäre ausgeführt wird;
dass das Phosphorschichtmaterial (3) ferner einen anorganischen Füllstoff enthält; und
dass der dritte Prozessschritt ferner das Zulassen, dass der in dem Phosphorschichtmaterial (3) enthaltene anorganische Füllstoff zwischen das lichtemittierende Element (1) und das Substrat (2) gefüllt wird, umfasst.

9. Verfahren nach Anspruch 8,
wobei der in dem Phosphorschichtmaterial (3) enthaltene Phosphor nicht zwischen das lichtemittierende Element (1) und das Substrat (2) gefüllt wird.

10. Verfahren nach Anspruch 8, das ferner nach dem dritten Prozessschritt einen Prozessschritt zum Hinzufügen eines Extraanteils des Phosphorschichtmaterials (3) zu dem Phosphorschichtmaterial (3), das das lichtemittierende Element (1) abdeckt, umfasst.

11. Verfahren nach Anspruch 8,
wobei der zweite Prozessschritt in einer Niederdruckatmosphäre mit einem Druck im Bereich von 20 Pa bis 100 Pa ausgeführt wird und der dritte Prozessschritt in einer Hochdruckatmosphäre mit einem Druck im Bereich von 10 kPa bis 90 kPa ausgeführt wird.

12. Verfahren nach Anspruch 8,
wobei in dem ersten Prozessschritt das lichtemittierende Element (1) mit dem Substrat (2) unter Verwendung eines Höckers (5) verbunden wird.

## Revendications

1. Source de lumière luminescente, comprenant :
un élément luminescent (1) ;
un substrat (2) comprenant un motif conducteur (4) ; et
un matériau en couche de phosphore (3) contenant un phosphore et un matériau de base transmetteur de lumière,
l'élément luminescent (1) étant connecté au motif conducteur (4) et le matériau en couche de phosphore (3) recouvrant l'élément luminescent (1),
dans laquelle le matériau de base transmetteur de lumière dans le matériau en couche de phosphore (3) est disposé entre l'élément luminescent (1) et le substrat (2),
**caractérisée en ce que** le matériau en couche de phosphore (3) contient par ailleurs une charge inorganique, et **en ce que** la charge inorganique dans le matériau en couche de phosphore (3) est disposée entre l'élément luminescent (1) et le substrat (2).

2. Source de lumière luminescente selon la revendication 1,
dans laquelle le phosphore n'est pas disposé dans le matériau en couche de phosphore (3) entre l'élément luminescent (1) et le substrat (2).

3. Source de lumière luminescente selon la revendication 1,
dans laquelle l'élément luminescent (1) est connecté au motif conducteur (4) en utilisant une protubérance (5).

4. Source de lumière luminescente selon la revendication 1,
dans laquelle le matériau de base transmetteur de lumière a une propriété qui consiste à avoir un facteur transmetteur spectrale supérieur ou égal à 70% à une longueur d'onde de crête d'émission de l'élément luminescent (1).

5. Source de lumière luminescente selon la revendication 1,
dans laquelle le matériau de base transmetteur de lumière est au moins l'un des matériaux sélectionné parmi une résine époxy, une résine de silicone et une résine fluorocarbonnée.

6. Source de lumière luminescente selon la revendication 1,
dans laquelle la charge inorganique est formée par l'un au moins parmi du dioxyde de silicium, de l'alumine, du nitrure d'aluminium, du nitrure de silicium, de l'oxyde de titane, et de l'oxyde de magnésium.

7. Appareil luminescent comprenant une pluralité de sources de lumière luminescentes telles que revendiquées dans l'une quelconque des revendications précédentes.

8. Procédé de fabrication d'une source de lumière luminescente, comprenant :
une première étape du procédé consistant à connecter un élément luminescent (1) à un substrat (2) comprenant un motif conducteur (4) via un espace ;
une deuxième étape du procédé consistant à recouvrir l'élément luminescent (1) connecté au substrat (2) avec un matériau en couche de phosphore (3) contenant un phosphore et un matériau de base transmetteur de lumière dans une atmosphère à basse pression d'une pression inférieure à la pression atmosphérique ; et
une troisième étape du procédé consistant à permettre de remplir avec le matériau de base transmetteur de lumière contenu dans le matériau en couche de phosphore (3) recouvrant l'élément luminescent (1) entre l'élément luminescent (1) et le substrat (2) ;
**caractérisé en ce que** la troisième étape est réalisée dans une atmosphère à pression plus élevée que l'atmosphère à basse pression ;
**en ce que** le matériau en couche de phosphore (3) contient par ailleurs une charge inorganique ; et
**en ce que** la troisième étape du procédé comprend en outre le fait de permettre de remplir avec la charge inorganique contenue dans le matériau en couche de phosphore (3) entre l'élément luminescent (1) et le substrat (2).

9. Procédé selon la revendication 8,
dans lequel on ne procède pas au remplissage pas avec le phosphore contenu dans le matériau en couche de phosphore (3) entre l'élément luminescent (1) et le substrat (2).

10. Procédé selon la revendication 8, comprenant en outre, après la troisième étape du procédé, une étape du procédé consistant à ajouter une partie supplémentaire de matériau en couche de phosphore (3) au matériau de couche de phosphore (3) recouvrant l'élément luminescent (1).

11. Procédé selon la revendication 8,
dans lequel la deuxième étape du procédé est réalisée dans une atmosphère à basse pression d'une pression de 20 Pa à 100 Pa, et la troisième étape du procédé étant réalisée dans une atmosphère à haute pression d'une pression de 10 kPa à 90 kPa.

12. Procédé selon la revendication 8,
dans lequel, au cours de la première étape du procédé, l'élément luminescent (1) est connecté au substrat (2) en utilisant une protubérance (5).
